# EUROPEAN PATENT SPECIFICATION

(11) **EP 4 078 093 B1**
(45) Date of publication and mention of the grant of the patent: **07.10.2026**
(21) Application number: 21706760.2
(22) Date of filing: 22.01.2021
(51) Int. Cl.: G01D 5/20, G01D 3/02

(54) **INDUCTIVE POSITION SENSORS**
INDUKTIVE POSITIONSSENSOREN
CAPTEURS INDUCTIFS DE POSITION

(30) Priority: 24.01.2020 US 202062965623 P
(43) Date of publication of application: 26.10.2022
(73) Proprietor: Sensata Technologies, Inc., Attleboro, MA 02703 (US)
(72) Inventor: MALOOF, James M., Attleboro, Massachusetts 02703 (US)
(74) Representative: FRKelly
(86) International application number: PCT/US2021/014636
(87) International publication number: WO 2021/150906

(56) References cited:
- WO-A1-97/19323
- GB-A- 2 503 006
- US-A1- 2004 227 644
- US-A1- 2019 195 963

## Description

### BACKGROUND

Inductive position sensors provide feedback to the control systems for electric motors. For synchronous motors, this feedback is required in order to calculate the phase currents necessary to obtain the desired torque and achieve maximum motor efficiency.

Inductive position sensors operate on two core principles: induction of electromotive force (EMF) in a wire loop and induction of eddy currents in conductive materials. EMF is induced by changing the magnetic flux through a wire loop. This can be done by either changing the area of the loop within the magnetic field or by changing the strength of the field. Eddy currents are induced by either placing a conductor in a changing magnetic field or by relative motion between a conductor and a magnetic field. US 2019/195963 A1 and GB 2 503 006 A disclose known inductive position sensors.

Inductive position sensors may result in inaccurate readings when the signal strength in the sensing coil is weak or has a low signal to noise ratio. While multiple receive coils may be combined to produce a stronger signal, this typically results in a larger form factor. Moreover, dead zones may occur in areas where signal traces intersect. Accordingly, there is a need to compensate for these drawbacks.

### SUMMARY OF INVENTION

The invention of the present disclosure is defined as set out in the appended set of claims. Embodiments in accordance with the present disclosure are directed to an inductive position sensor having phase blended, arrayed, multiloop inductive coils with layout compensated geometry. The phase blended, arrayed, multiloop inductive coils with layout compensated geometry increase signal strength on receive coils of an inductive position sensor, decrease the number of printed circuit board or printed film layers, provide the purest intended sinusoidal response signal for optimal sensor performance, allow functionality and maintain signal quality in broad range of form factors and application requirements, and decrease susceptibility to sensor and system variable's tolerance ranges and stacks. By increasing the signal strength in the receive coils, the signal to noise ratio may be increased, thresholds for proper signal conditioning can be met, and sensor sensitivity to target position under all application conditions (e.g., airgap and temperature ranges) can be improved.

Embodiments in accordance with the present disclosure increase performance and differentiation for an inductive position sensor, such as those used in electric motor applications, through improvements to the sense element and target design. The sense element coils are arrayed in several manners as described herein. Furthermore, the coil and target geometry are manipulated to compensate for inherent errors in the fundamental concept.

For inductive position sensing, the basic operating principles are used by pairing a sensing element and a conductive target. Used in conjunction, the rotation of the target over the sensing elements provides output signals that can be captured with an application specific integrated circuit (ASIC) and provided to, for example, a vehicle electronic control unit (ECU).

In some embodiments, a particular loop in the first plurality of arrayed loops includes a first trace pattern in a first conductive layer, a second trace pattern in a second conductive layer, and a plurality of vias connecting the first trace pattern and the second trace pattern, and via pads corresponding to vias are located outside of an intended sensing area of the particular loop. In some embodiments, a layout of a trace pattern for a particular loop is biased such that an edge of the trace pattern adjacent an intended sensing area is used as a signal reference. In some embodiments, a trace pattern geometry for the first plurality of arrayed loops and the second plurality particular loops is compensated for a dead zone at an intersection of two loops.

In some embodiments, a particular loop in the first plurality of arrayed loops includes a first trace pattern in a first conductive layer, a second trace pattern in a second conductive layer, and the first conductive layer and the second conductive layer are composed of conductive ink on printed film. In some embodiments, crossovers between trace segments in the first receive coil and the second receive coil occur at natural transition points where conductor traces intersect. In some embodiments, at least the first plurality of arrayed loops are asymmetric.

In some embodiments, the first receive coil and the second receive coil are arranged in a hanging coil layout. In these embodiments, the hanging coil layout may be a grouped hanging coil layout. In these embodiments, the hanging coil layout may be an individually spaced hanging coil layout. In these embodiments, the hanging coil layout may be a split hanging coil layout. In some embodiments, the target is selected to be less than half an electrical period of the sensor.

The foregoing and other objects, features and advantages of the invention will be apparent from the following more particular descriptions of exemplary embodiments of the invention as illustrated in the accompanying drawings wherein like reference numbers generally represent like parts of exemplary embodiments of the invention.

### BRIEF DESCRIPTION OF DRAWINGS

FIG. 1 illustrates an example angularly arrayed receive coil layout in accordance with an embodiment of the present disclosure;
FIG. 2 illustrates an example radially arrayed receive coil layout by full coil width in accordance with an embodiment of the present disclosure;
FIG. 3 illustrates an example two signal, angularly and radially arrayed, receive coil layout in accordance with an embodiment of the present disclosure;
FIG. 4 illustrates an example X arrayed linear receive coil layout in accordance with an embodiment of the present disclosure;
FIG. 5 illustrates an example X and Y arrayed linear receive coil layout in accordance with an embodiment of the present disclosure;
FIG. 6A illustrates an example conductor layout for a first coil layer of a receive coil in accordance with an embodiment of the present disclosure;
FIG. 6B illustrates an example conductor layout for a second coil layer of the receive coil of FIG. 6B in accordance with an embodiment of the present disclosure;
FIG. 7A illustrates another example conductor layout in accordance with an embodiment of the present disclosure;
FIG. 7B illustrates a first layer of the coil layout of FIG. 7A in accordance with an embodiment of the present disclosure.
FIG. 7C illustrates a second layer of the coil layout in accordance with an embodiment of the present disclosure.
FIG. 8 illustrates an example conductor layout in accordance with an embodiment of the present disclosure;
FIG. 9 illustrates an example of an ideal sinusoid;
FIG. 10 illustrates an example conductor trace using an ideal sinusoid midline;
FIG. 11A illustrates an example compensated geometry for conductor trace crossover in accordance with the present disclosure;
FIG. 11B illustrates the offset traces of FIG. 11A in accordance with an embodiment of the present disclosure.
FIG. 12 illustrates an example trace crossover to eliminate dead zones in accordance with an embodiment of the present disclosure;
FIG. 13 illustrates an example coil layout and target starting position for a single coil sense element in accordance with embodiments of the present disclosure;
FIG. 14 illustrates an example coil layout and target starting position for a dual coil with 45° phase shift sense element in accordance with embodiments of the present disclosure;
FIG. 15 illustrates a plot of receive coil cross sectional width vs mechanical angle;
FIG. 16 illustrates a plot of error range (electrical angle) vs. coil width for an example inductive position sensor in accordance with embodiments of the present disclosure;
FIG. 17 illustrates a plot of error range (electrical angle) vs. trace width for an example inductive position sensor in accordance with embodiments of the present disclosure;
FIG. 18 illustrates crossover width variance with respect to coil width for an example inductive position sensor in accordance with embodiments of the present disclosure;
FIG. 19 illustrates a plot of electrical angle vs. mechanical position for an example inductive position sensor in accordance with embodiments of the present disclosure;
FIG. 20 illustrates an example trace pattern for a receive coil layout in accordance with embodiments of the present disclosure;
FIG. 21A illustrates an example trace pattern for a first signal in the example of FIG. 20 in accordance with embodiments of the present disclosure;
FIG. 21B illustrates an example trace pattern for a second signal in the example of FIG. 20 in accordance with embodiments of the present disclosure;
FIG. 22 illustrates an example hanging coil layout in accordance with embodiments of the present disclosure;
FIG. 23 illustrates example grouped hanging coil layout in accordance with embodiments of the present disclosure;
FIG. 24 illustrates example individually spaced hanging coil layout in accordance with embodiments of the present disclosure;
FIG. 25 illustrates a hanging coil layout that is a grouped split hanging coil layout in accordance with embodiments of the present disclosure;
FIG. 26 illustrates a hanging coil layout that is an individually spaced split hanging coil layout in accordance with embodiments of the present disclosure;
FIG. 27A illustrates one pattern of the hanging coil layout of FIG. 26;
FIG. 27B illustrates another pattern of the hanging coil layout of FIG. 26;
FIG. 28A illustrates an example symmetric coil pattern in accordance with the present disclosure;
FIG. 28B illustrates an example loop shape of the symmetric coil pattern of FIG. 28A;
FIG. 29A illustrates an example asymmetric coil pattern in accordance with the present disclosure;
FIG. 29B illustrates an example loop shape of the asymmetric coil pattern of FIG. 29A;
FIG. 30 illustrates a symmetric loop shape and an asymmetric loop shape in accordance with the present disclosure on a linear scale; and
FIG. 31 sets forth a flow chart illustrating an example method for an inductive position sensor in accordance with the present disclosure.

### DESCRIPTION OF EMBODIMENTS

The terminology used herein for the purpose of describing particular examples is not intended to be limiting for further examples. Whenever a singular form such as "a", "an" and "the" is used and using only a single element is neither explicitly or implicitly defined as being mandatory, further examples may also use plural elements to implement the same functionality. Likewise, when a functionality is subsequently described as being implemented using multiple elements, further examples may implement the same functionality using a single element or processing entity. It will be further understood that the terms "comprises", "comprising", "includes" and/or "including", when used, specify the presence of the stated features, integers, steps, operations, processes, acts, elements and/or components, but do not preclude the presence or addition of one or more other features, integers, steps, operations, processes, acts, elements, components and/or any group thereof.

It will be understood that when an element is referred to as being "connected" or "coupled" to another element, the elements may be directly connected or coupled via one or more intervening elements. If two elements A and B are combined using an "or", this is to be understood to disclose all possible combinations, i.e., only A, only B, as well as A and B. An alternative wording for the same combinations is "at least one of A and B". The same applies for combinations of more than two elements.

Accordingly, while further examples are capable of various modifications and alternative forms, some particular examples thereof are shown in the figures and will subsequently be described in detail. However, this detailed description does not limit further examples to the particular forms described. Further examples may cover all modifications, equivalents, and alternatives falling within the scope of the disclosure. Like numbers refer to like or similar elements throughout the description of the figures, which may be implemented identically or in modified form when compared to one another while providing for the same or a similar functionality.

In embodiments in accordance with the present disclosure, an inductive position sensor in a sensing element has output signals that are two phase shifted sinusoidal signals which allow for a ratiometric measurement in order to track angular position by taking the arctan. The sensing element, which is directly connected to an integrated circuit (e.g., an application specific integrated circuit (ASIC)) includes a transmit coil and two receive coils. The transmit coil generates a magnetic field that is received by the receive coils. Driven by the integrated circuit, and in parallel with a capacitor, the transmit coil acts as a LC oscillator circuit. The LC oscillator generates a magnetic field that is the transmitted signal to the receive coils. The polarity of the magnetic field is determined by the direction of the current in the loop. The two receive coils are wire loops, connected to the integrated circuit, that exist within the oscillating magnetic field generated by the transmit coil. The field induces current flow in the coils and an EMF proportional to the area of the magnetic field within each of the wire loops.

In some embodiments, the design of each receive coil creates multiple wire loops in the coil that have opposing EMF generation. Without the target present, the summation of the EMF for a given receive coil is designed to be zero volts. This voltage signal is the input to the integrated circuit. Each coil is designed with a specified target to provide a sinusoidal change in voltage as the target moves from one point over the position sensor to another. In some embodiments, the target is a conductive material that interacts with the magnetic field generated by the transmit coil. When placed above the coil, the field induces eddy currents within the conductive target. The eddy currents then generate a second magnetic field which, according to Lenz's Law, opposes the initial magnetic field that interacted with the target. The result is an attenuated magnetic field in the area below (near) the target. The sensing element and the conductive target together generate a position signal. With the target present over a given wire loop, the attenuated magnetic field results in a change in the EMF generation for the effected loop. The delta is used to track the position of the target. To accomplish this, the two receive coils are identical and phase shifted by 90°. This results in a sine and a cosine output of which the arctan can be taken to calculate the position of the target.

In embodiments in accordance with the present disclosure, arrayed coil loops (e.g., phase blended, multiloop) may be implemented on either linear (X,Y,Z) or angular (θ,R,Z) sensors. When connected in series, receive coils arrayed in the Y (linear) dimension or the R (radial) dimension result in summed sinusoids that are phase aligned to generate a sinusoid of greater amplitude. Multiple coil loop sets that are offset in the Y (linear) dimension or the R (radial) dimension gain the benefit of each individual coil having greater field uniformity to provide a cleaner signal. Receive coil loop sets arrayed in the X (linear) dimension or the θ (angular) dimension result in summed sinusoids that are phase blended to the mean position of each of the coils with a greater amplitude. Coils may be arrayed in the X or θ dimensions by a full electrical period, however the phase blended coils are arrayed by less than a full electrical cycle with the optimal phase separation values being dependent on the number of receive coils and signal transform method (i.e., 2 or 3 phase sinusoids). In various embodiments, angular sensors may be implemented as 360° sensors or arc sensors. As used herein, "phase blended" refers to angularly arrayed coil loop sets in 360° sensors or arc sensors, or X-arrayed coil loop sets in a linear sensor. As used herein, "amplitude arrayed" refers to radially arrayed coil loop sets in 360° sensors or arc sensors, or Y-arrayed coil loop sets in a linear sensor.

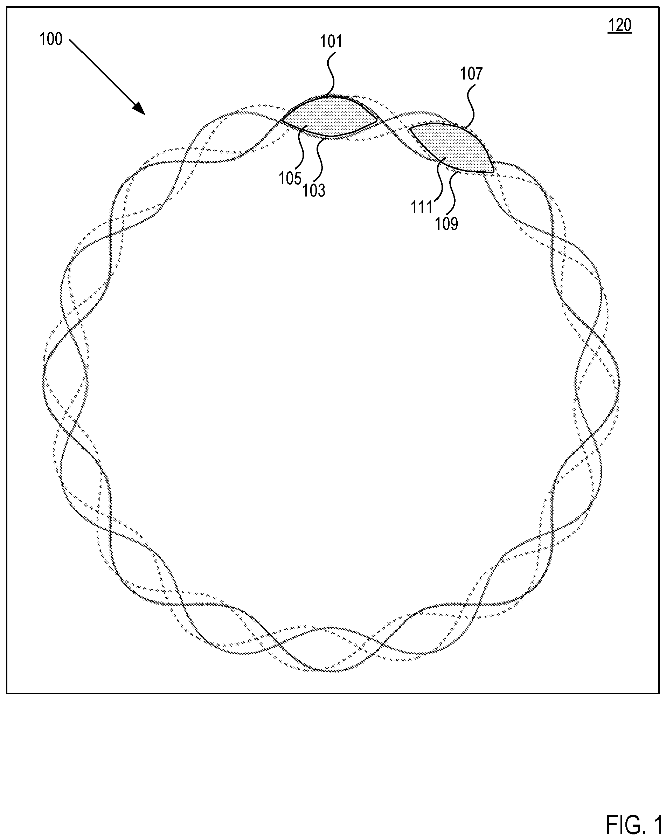

Exemplary apparatuses and methods for an inductive position sensor in accordance with the present disclosure are described with reference to the accompanying drawings, beginning with FIG. 1. FIG. 1 illustrates an example coil layout of a single receive coil (100) of position sensor that is angularly arrayed (i.e., θ arrayed) in accordance with the present disclosure. In the example of FIG. 1, the receive coil (100) includes a first set of sinusoidal loops having a first sinusoidal trace pattern (101) (e.g., a sine wave) and a second sinusoidal trace pattern (103) that is the reflection of the first sinusoidal trace pattern (101). In some embodiments, sinusoidal trace patterns (101, 103) are formed on same plane (i.e., conductive layer) or different planes of a sense element (120) (e.g., a multilayered PCB or printed film structure). In some embodiments, portions of each sinusoidal trace pattern (101, 103) are formed on one plane while other portions of each sinusoidal trace patterns (101, 103) are formed on a different plane. The sinusoidal trace patterns (101, 103) define coil loops surrounding an intended sensing areas (105) for detecting a magnetic field attenuated by the target when the target is over an intended sensing area (105). When the target is present over the intended sensing area (105), the attenuated magnetic field creates a change in the EMF generation of the affected loop, which is detectable from the signal on the sinusoidal trace patterns (101, 103).

In the example of FIG. 1, the receive coil (100) also includes a second set of sinusoidal loops having a first phase-shifted sinusoidal trace pattern (107) and a second phase-shifted sinusoidal trace pattern (109) that is the reflection of the first phase-shifted sinusoidal trace pattern (107), where the phase-shifted sinusoidal trace patterns (107, 109) are phase-shifted relative to the sinusoidal trace patterns (101, 103). In some embodiments, phase-shifted sinusoidal trace patterns (107, 109) are formed on same plane (i.e., conductive layer) or different planes of the sense element (120). In some embodiments, portions of each phase-shifted sinusoidal trace pattern (107, 109) are formed on one plane while other portions of each phase-shifted sinusoidal trace patterns (107, 109) are formed on a different plane. The sinusoidal trace patterns (107, 109) define coil loops surrounding an intended sensing areas (111) for detecting a magnetic field attenuated by the target when the target is over an intended sensing area (111). When the target is present over the intended sensing area (111), the attenuated magnetic field creates a change in the EMF generation of the affected loop, which is detectable from the signal on the sinusoidal trace patterns (107, 109). By summing the measured EMF generation in the intended sensing areas (105, 111) and correlating the summed measurement to a mean position of the intended sensing areas, an enhanced position signal for the location of the target with respect to the sense element (120) is generated. The enhanced position signal has double the amplitude of a signal derived from a single sense area.

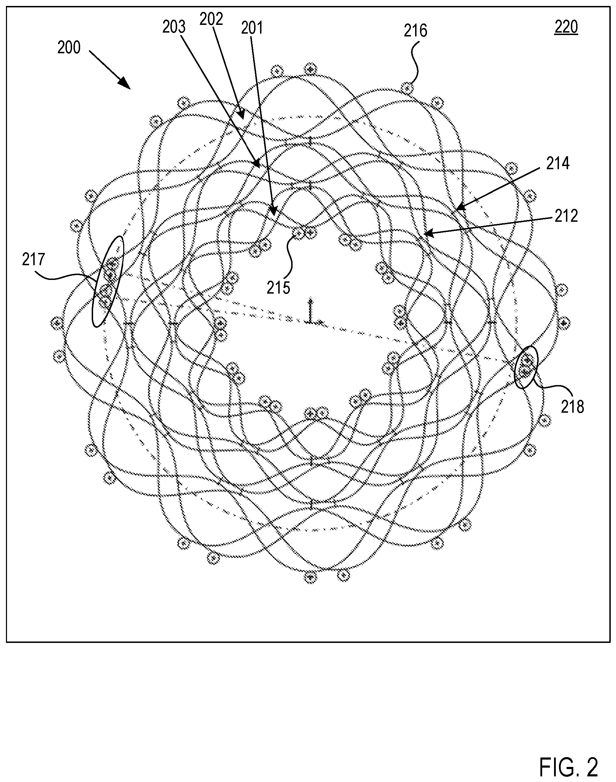

For further explanation, FIG. 2 illustrates an example coil layout of a single receive coil (200) of an angular sensor that is phase arrayed (angularly arrayed) and radially arrayed (i.e., R arrayed) in accordance with some embodiments of the present disclosure. In the example of FIG. 2, the receive coil (200) includes an angularly arrayed coil that is radially arrayed three times with coil patterns (201, 202, 203) and connected in series. In this example, each coil pattern (201, 202, 203), like the receive coil (100) in FIG. 1, includes a first set of sinusoidal loops having a first sinusoidal trace pattern (e.g., a sine wave) and a second sinusoidal trace pattern that is the reflection of the first sinusoidal trace pattern, as well as a second set of sinusoidal loops having a first phase-shifted sinusoidal trace pattern and a second phase-shifted sinusoidal trace pattern that is the reflection of the first phase-shifted sinusoidal trace pattern, where the phase-shifted sinusoidal trace patterns are phase-shifted relative to the sinusoidal trace patterns. Each aligned loop of the coils (201, 202, 203) are connected by trace segments (212, 214). As the coils are connected in series, the three coils are driven by the same signal output from an integrated circuit. As a result, an enhanced position signal for the location of the target with respect to the sense element (220) can be generated by summing the sinusoids of phase aligned loops, summing the sinusoids that are phase blended, and correlating the resulting sum to a mean position of the phase blended loops.

In some embodiments, portions of each sinusoidal trace pattern in each coil are formed on one plane while other portions of that sinusoidal trace pattern are formed on a different plane such as top and bottom layers of a PCB or various layers of a multilayer PCB. In some examples, an inner ring of vias (215) and an outer ring of vias (216) allow a signal to propagate between layers. Vias (217) may be used for crossovers between positive and negative windings, and vias (218) may be used for crossovers between phase windings.

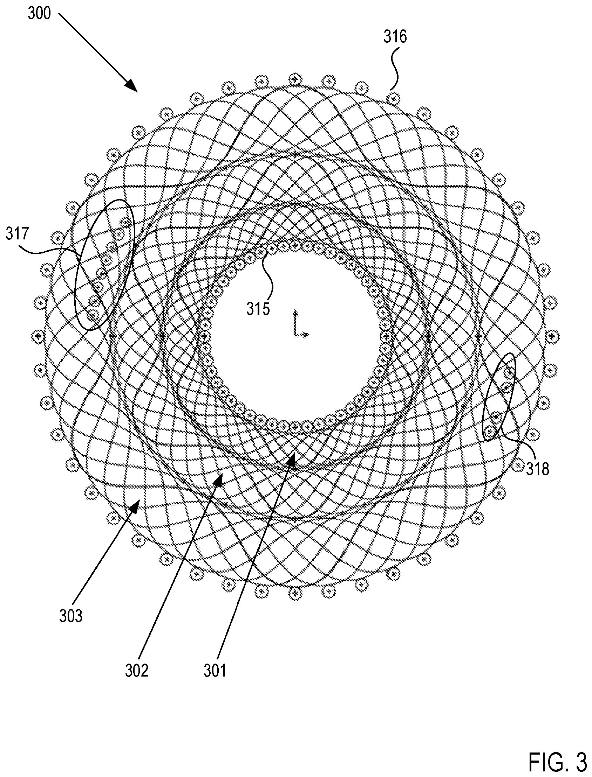

For further explanation, FIG. 3 illustrates an example two signal (e.g., sine and cosine) angularly arrayed and radially arrayed receive coil layout (300) in accordance with some embodiments of the present disclosure. The receive coil layout includes three dual coil patterns (301, 302, 303) that are radially arrayed. Each dual coil pattern (301, 302, 303) includes a first angularly arrayed coil corresponding to a first signal (e.g., sine) and a second angularly arrayed coil corresponding to a second signal (e.g., cosine). Each angularly arrayed coil includes a first set of sinusoidal loops and a second set of sinusoidal loops that are phase-shifted with respect to the first set of sinusoidal loops. Because the first angularly arrayed coil and the second angularly arrayed coil are phase-shifted with respect to each other (e.g., 90°), the resulting coil pattern includes two sets of phase blended loops. The first angularly arrayed coils corresponding the first signal in each dual coil pattern (301, 302, 303) are connected in series to form a first receive coil. Phase-aligned loops in the first angularly arrayed coils of each dual coil pattern are amplitude summed. Phase blended loops in the first receive coil are summed and correlated to the mean position of the loops. The second angularly arrayed coils corresponding the second signal in each dual coil pattern (301, 302, 303) are connected in series to form a second receive coil. Phase-aligned loops in the second angularly arrayed coils of each dual coil pattern are amplitude summed. Phase blended loops in the second receive coil are summed and correlated to the mean position of the loops.

In some embodiments, portions of each sinusoidal trace pattern in each receive coil are formed on one plane while other portions of that sinusoidal trace pattern are formed on a different plan, for example, where different planes are top and bottom layers of a PCB or various layers of a multilayer PCB. In some examples, an inner ring of vias (315) and an outer ring of vias (316) allow a signal to propagate between layers. Vias (317) may be used for crossovers between positive and negative windings, and vias (318) may be used for crossovers between phase windings.

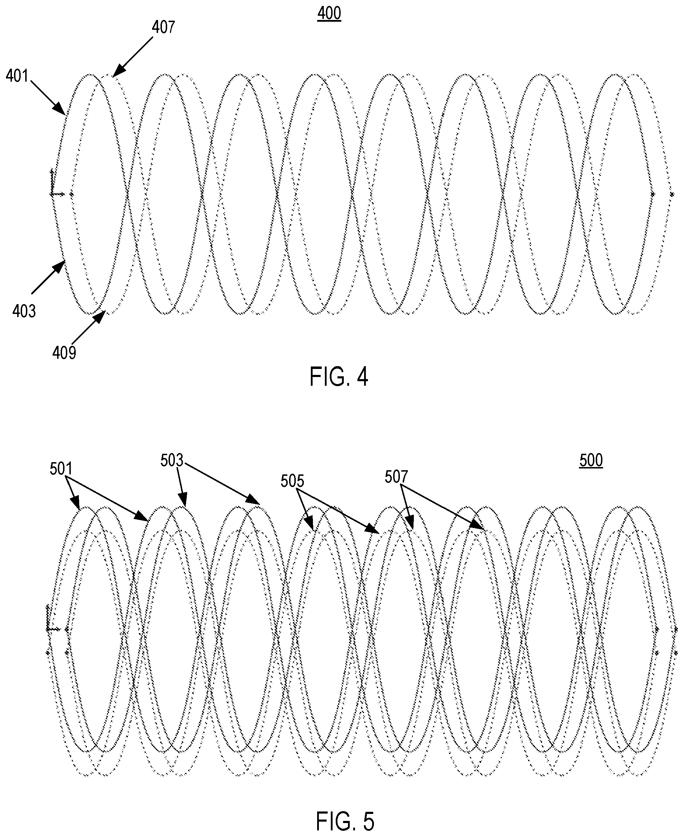

For further explanation, FIG. 4 illustrates an example X arrayed linear receive coil layout (400) in accordance with some embodiments of the present disclosure. The example receive coil layout (400) shows a single receive coil that includes a first set of sinusoidal loops having a first sinusoidal trace pattern (401) (e.g., a sine wave) and a second sinusoidal trace pattern (403) that is the reflection of the first sinusoidal trace pattern (401). The receive coil layout (400) also includes a second set of sinusoidal loops having a first phase-shifted sinusoidal trace pattern (407) and a second phase-shifted sinusoidal trace pattern (409) that is the reflection of the first phase-shifted sinusoidal trace pattern (407) (both shown in dashed lines for clarity), where the phase-shifted sinusoidal trace patterns (407, 409) are phase-shifted relative to the sinusoidal trace patterns (401, 403).

For further explanation, FIG. 5 illustrates an example X and Y arrayed linear receive coil layout (500) in accordance with some embodiments of the present disclosure. The example receive coil layout (500) shows a single receive coil that includes a first set (501) of loops formed from a sinusoidal trace pattern (e.g., a sine wave) and its reflection. The receive coil layout (500) also includes a second set (503) of loops that are phase-shifted relative to the first set (501) of loops. The receive coil layout (500) also includes a third set (505) of loops formed from another sinusoidal trace pattern (e.g., a sine wave) and its reflection. The receive coil layout (500) also includes a fourth set (507) of loops that are phase-shifted relative to the third set (505) of loops. The first and second set of sinusoidal loops are Y-arrayed with respect to the third and fourth set of sinusoidal loops (shown in dashed lines for clarity).

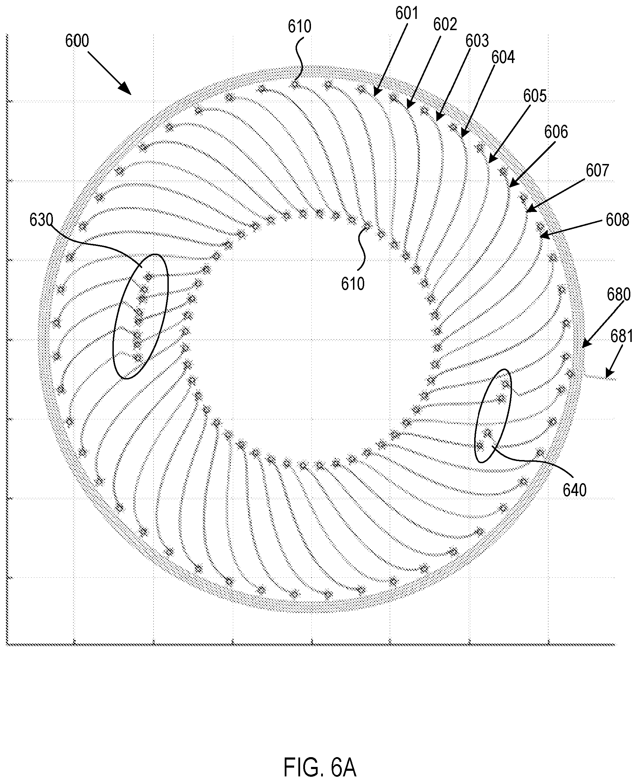

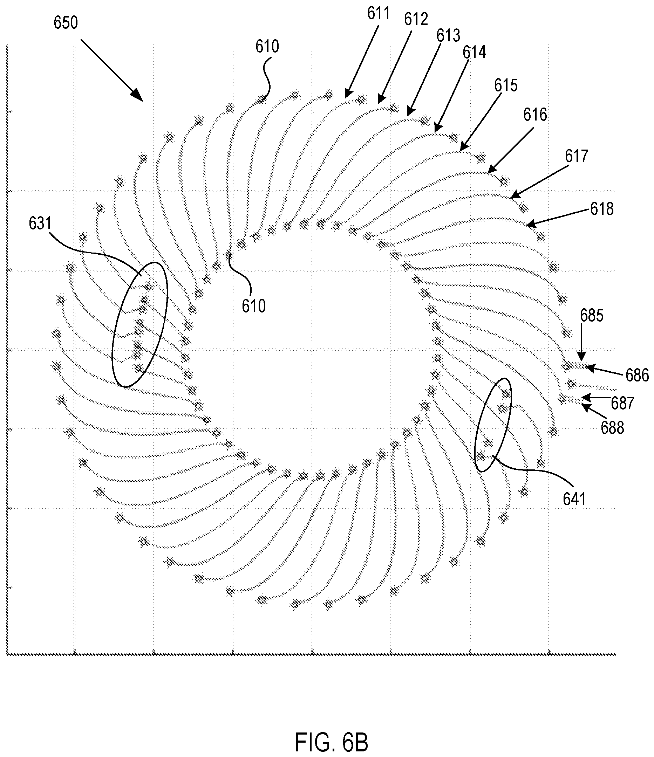

For further explanation, FIG. 6A illustrates a coil layout (600) for a top layer of a dual coil pattern for two receive coils corresponding to distinct signal patterns (e.g., sine and cosine) and FIG. 6B illustrates a coil layout (650) for a bottom layer of a dual coil pattern for two receive coils corresponding to the distinct signal patterns, in accordance with some embodiments of the present disclosure. For example, the coil layout (600) may be disposed on a top layer of a PCB and coil layout (650) may be disposed on a bottom layer of the PCB. The coil layout (600) includes a transmit signal input line (681) and a transmit coil (680) that loops around a dual receive coil layout described below.

In FIG. 6A, the coil layout (600) includes a first receive signal coil pattern that is angularly arrayed and a second receive coil that is also angularly arrayed, where the first receive coil and the second receive signal coil pattern are themselves angularly arrayed with respect to each other. The coil layout (600) includes sets of trace segments that correspond to portions of sinusoidal patterns. In the example of FIG. 6A, trace segment (601) corresponds to a portion of a first sinusoidal pattern (e.g., sine) of the first signal, trace segment (603) corresponds to a portion of a first sinusoidal pattern (e.g., cosine) of the second signal, trace segment (602) corresponds to a portion of a second sinusoidal pattern (e.g., phase-shifted sine) of the first signal that is phase-shifted with respect to the first sinusoidal pattern of the first signal, and trace segment (604) corresponds to a portion of a second sinusoidal pattern (e.g., phase-shifted cosine) of the second signal that is phase-shifted with respect to the first sinusoidal pattern of the second signal. The adjacent set of trace segments (605, 606, 607, 608) follow a reverse direction of the signal patterns respectively corresponding to trace segments (601, 602, 603, 604). Forward direction sets of trace segments (601, 602, 603, 604) alternate with reverse direction sets of trace segments (605, 606, 607, 608) around the sensor in that in that each sinusoidal pattern loops around the sensor before reversing direction to form a reflection of the forward direction pattern. Each sinusoidal pattern reverses direction at a natural junction point (e.g., where the current in the signal reverses). In the example, of FIG. 6A, the sinusoidal patterns (e.g., sine, cosine, phase-shifted sine, phase-shift cosine) reverse direction at via pairs (630). Similarly, initial signal patterns (e.g., sine and cosine) transition to phase-shifted signal patterns (e.g., phase-shift sine and phase-shifted cosine) at via pairs (640).

Trace segments in the coil layout (600) of FIG. 6A connect to trace segments in the coil layout (650) of FIG. 6B through vias (610) between the top layer in FIG. 6A and the bottom layer in FIG. 6B. To minimize crossovers between signals and phases of signals, trace segments corresponding to portions of the sinusoidal pattern with increasing amplitude are disposed on one layer and trace segments corresponding to portions of the sinusoidal pattern with decreasing amplitude are disposed on a different layer, with pass through vias connecting the increasing portions to the decreasing portions. For example, trace segments (601, 602, 603, 604) in FIG. 6A connect to trace segments (611, 612, 613, 614) in FIG. 6B and trace segments (605, 606, 607, 608) in FIG. 6A connect to trace segments (615, 616, 617, 618) in FIG. 6B.

In the example coil layout (650) of FIG. 6B, like the example coil layout (600) of FIG. 6A, trace segment (611) corresponds to a portion of a first sinusoidal pattern (e.g., sine) of the first signal, trace segment (613) corresponds to a portion of a first sinusoidal pattern (e.g., cosine) of the second signal, trace segment (612) corresponds to a portion of a second sinusoidal pattern (e.g., phase-shifted sine) of the first signal that is phase-shifted with respect to the first sinusoidal pattern of the first signal, and trace segment (614) corresponds to a portion of a second sinusoidal pattern (e.g., phase-shifted cosine) of the second signal that is phase-shifted with respect to the first sinusoidal pattern of the second signal. The adjacent set of trace segments (615, 616, 617, 618) follow a reverse direction of the signal patterns respectively corresponding to trace segments (611, 612, 613, 614). Forward direction sets of trace segments (611, 612, 613, 614) alternate with reverse direction sets of trace segments (615, 616, 617, 618) around the sensor in that in that each sinusoidal pattern loops around the sensor before reversing direction to form a reflection of the forward direction pattern. Each sinusoidal pattern reverses direction at a natural junction point (e.g., zero amplitude). In the example, of FIG. 6B, the sinusoidal patterns (e.g., sine, cosine, phase-shifted sine, phase-shift cosine) reverse direction at via pairs (631). Similarly, initial signal patterns (e.g., sine and cosine) transition to phase-shifted signal patterns (e.g., phase-shift sine and phase-shifted cosine) at via pairs (641).

In the example of FIG. 6B, the coil layout (650) also includes the input and output lines (685, 686) for the first receive coil, the input and output lines (687, 688) for the second receive coil, and the output line for the transmit coil (680). When superimposed, trace segments in coil layout (600) of FIG. 6A and trace segments in coil layout (650) in FIG. 6B form four sinusoidal patterns that loop around the sensor for a two signal sense element. In such a configuration, two phases of each signal are blended to improve the signal to noise ratio (SNR). The arctan of the sine and cosine receive signals may be calculated to determine the position of a target over the sense element.

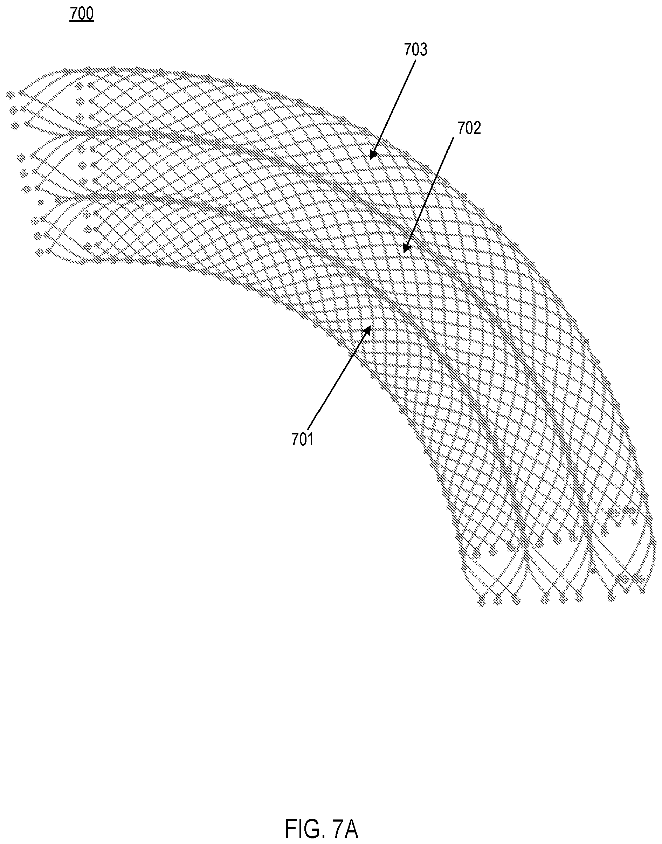

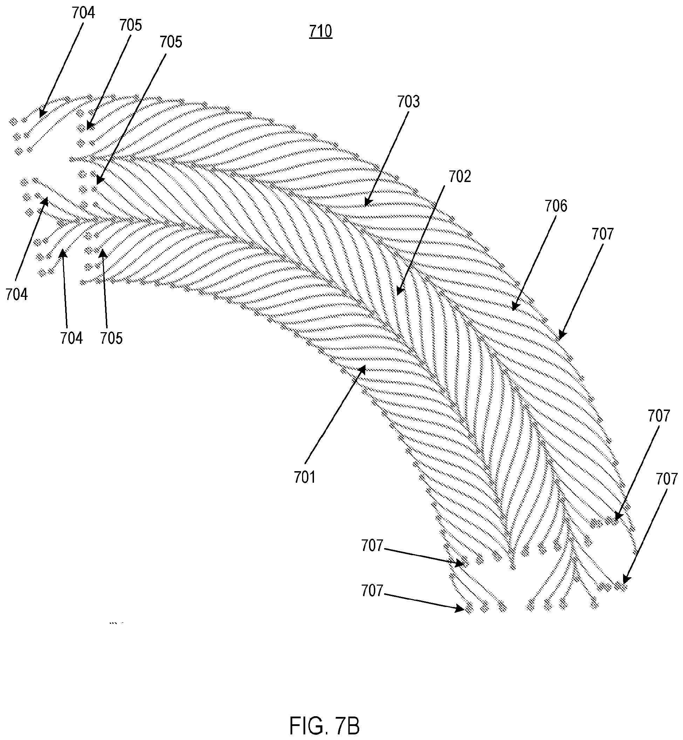

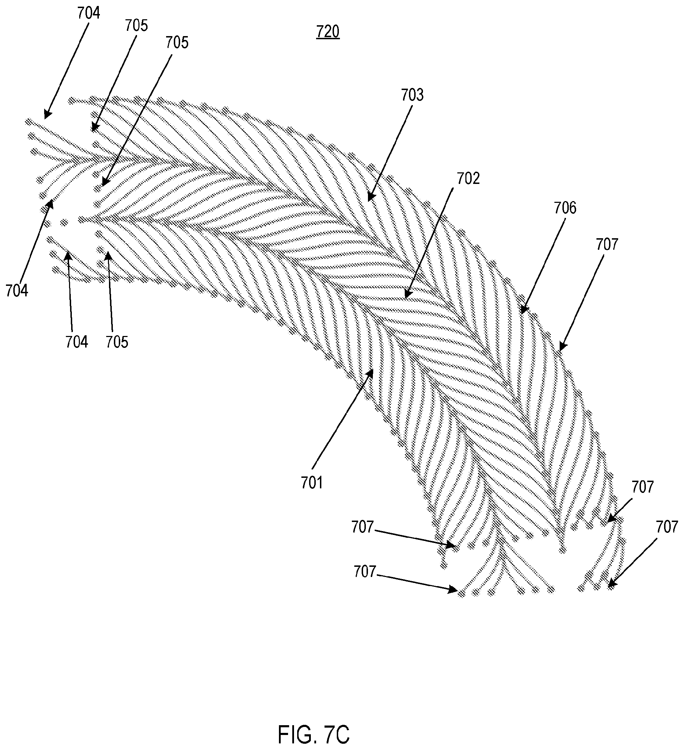

For further explanation, FIG. 7A illustrates an example coil layout (700) for an arc sensor, FIG. 7B illustrates a first layer (710) of the coil layout (700), and FIG. 7C illustrates a second layer (720) of the coil layout (700), in accordance with some embodiments of the present disclosure. In some examples, the first layer (710) is formed on a top layer of a sense element PCB and the second layer is formed on the bottom layer of the PCB. The coil layout (700) includes three radially arrayed coil patterns (701, 702, 703) that are connected in series. Each coil pattern includes two signal patterns (704, 705) corresponding to two signals (e.g., sine and cosine). Each signal pattern is angularly-arrayed with three replicates. Trace segments (706) for the signal patterns on one layer (710) convey the signal in opposing directions (i.e., outward vs. inward or increasing vs. decreasing) on the other layer (720). Vias (707) are used to pass a signal from the first layer (710) to the second layer (720) forming a signal pattern on first layer (710) and a reflection of the signal pattern on the second layer (720) to create a sinusoidal signal pattern.

In some embodiments in accordance with the present disclosure, coil loops may also be arrayed in the Z axis, which is normal to the plane of the transmit coil. Coil loops may be arrayed in the Z axis by stacking layers of the medium used for placing the conductors if the conducting segments are isolated from one another by an insulating layer. By way of example and not limitation, stacking coil loops may be carried out by using multilayer PCBs with offset via positioning, multilayer PCBs with hidden vias on alternating layers, or by using conductive ink on printed film with printed insulation layers between crossover segments. Minimizing the thickness of the overall coil stack ensures a more uniform magnetic field throughout the thickness. In some embodiments, the use of conductive ink on printed film minimizes the thickness of the stack and therefore provides the most optimal magnetic field.

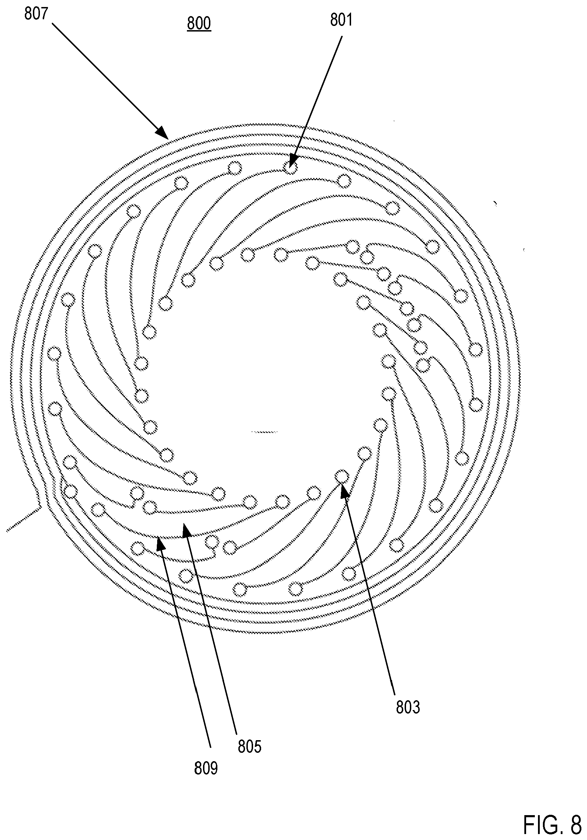

For further explanation, FIG. 8 illustrates a detailed view of an example layer of a coil layout (800) in accordance with some embodiments of the present disclosure. The coil layout (800) is biased such that the edge, not the centerline, of the conductive trace (809) adjacent to the intended sensing area (805) is the reference used to generate the signal output. In other words, the edges of the conductive traces align with the sinusoidal signal that defines the sensing area rather than the center of the conductive traces aligning the sinusoidal signal.

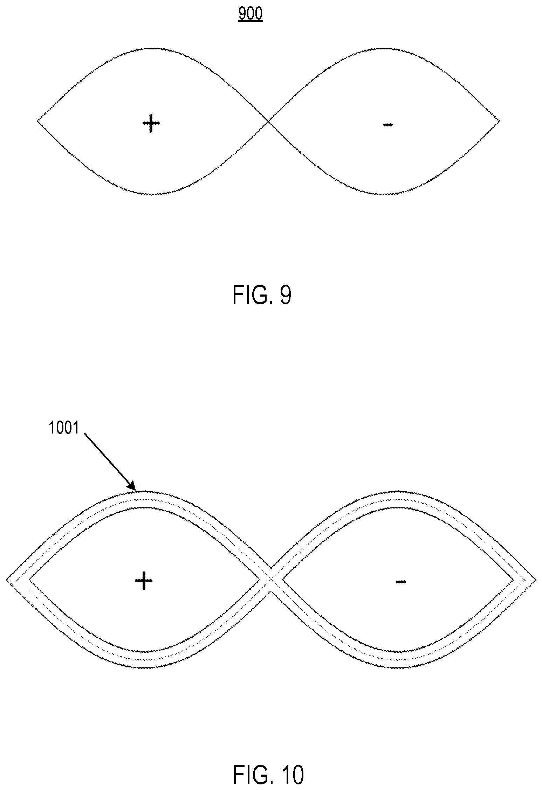

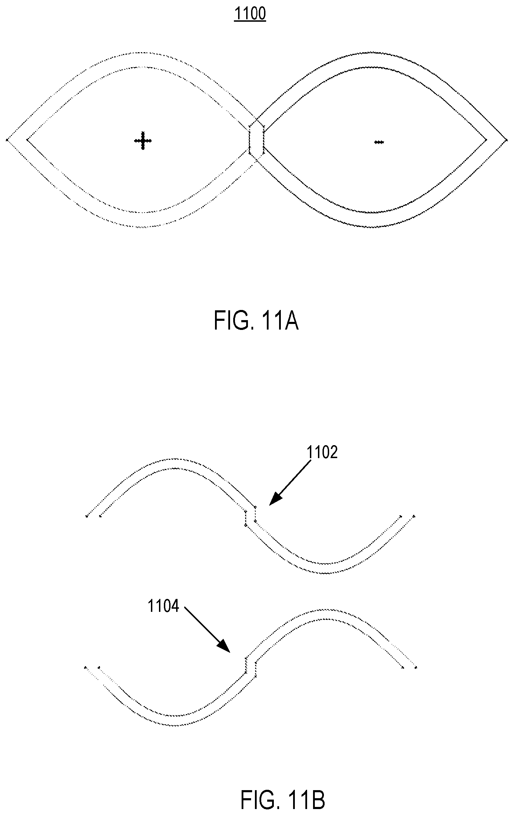

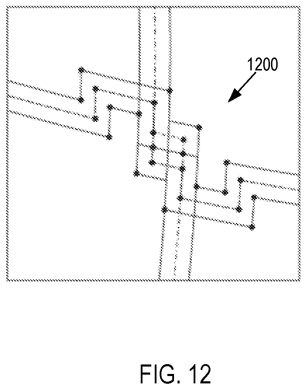

Using ideal sinusoidal geometry to generate PCB traces, if not considering the trace width of the conductor material, will result in a perfect sinusoidal response as the target travels over the coil loops from the positive loop to the negative loop, as shown by the example ideal sinusoidal geometry (900) depicted in FIG. 9. In the example of FIG. 9, it is assumed that current flowing in a clockwise direction creates a positive loop and current flowing in a counterclockwise direction creates a negative loop. When a sinusoidal signal in a first loop crosses the midline into the adjacent second loop, the current within the second loop flows in a reverse direction with respect to the first loop. When including the PCB conductor trace width, the positive and negative loops are disjointed, as shown by the conductor trace layout (1001) depicted in FIG. 10. This creates a dead zone at the transition point between the loops that disrupts the sinusoidal output that is desired from the target traveling over the coil resulting in residual errors in the signal. In some embodiments, the traces are offset outward by width of the trace to reduce the amount of error resulting from a dead zone, as shown in the compensated geometry (1100) FIG. 11A. FIG. 11B illustrates the offset traces of FIG. 11A where a first portion (1102) of the geometry (1100) is implemented on one layer of a PCB and a second portion (1104) of the geometry (1100) is implemented on another layer of the PCB. In other embodiments, a dead zone may be substantially eliminated using the crossover geometry (1200) depicted in FIG. 12. Additionally, as previously discussed crossovers between loops and coil sets occur at natural transition points where conductor trace segments intersect, as to not introduce any unintended changes to the sensing area and resulting output signal.

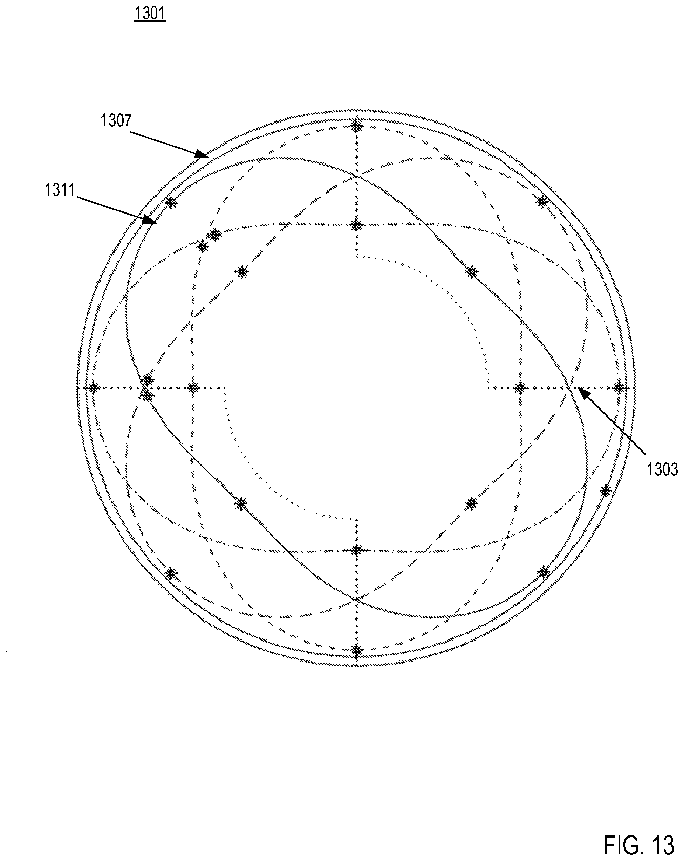

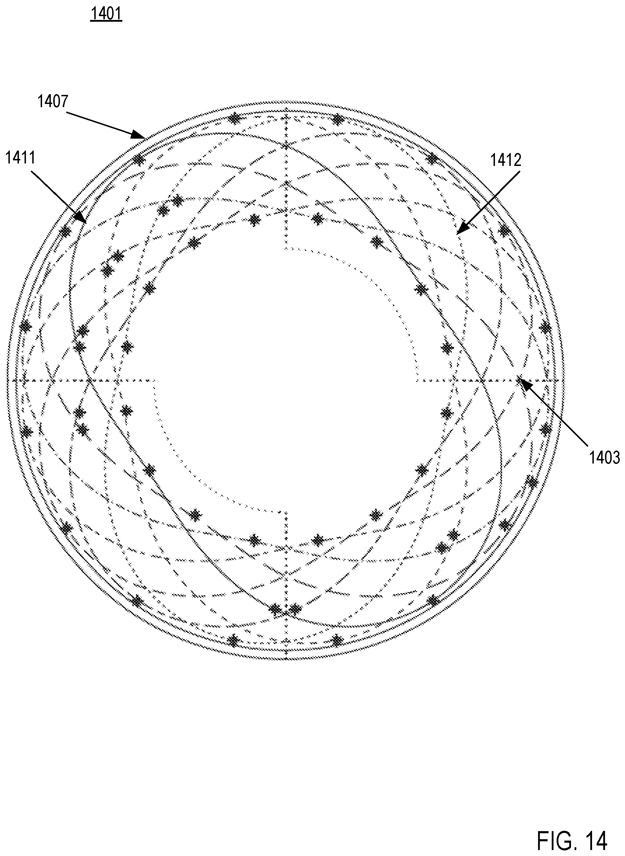

The geometry of the target is also selected to improve the intended signal output. FIG. 13 illustrates an exemplary coil layout (1301) and target (1303) starting position for a single receive coil sense element in accordance with some embodiments of the present disclosure. FIG. 14 illustrates an exemplary coil layout (1401) and target (1403) starting position for a dual receive coil with 45° phase shift sense element in accordance with some embodiments of the present disclosure. As shown in FIGS. 13 and 14, ensuring that the target (1303, 1403) overhangs the receive coils (1311, 1411, 1412) and transmit coils (1307, 1407) improves the output of the sensor. Additionally, the width of a target is conventionally equal to the width of half an electrical period. Whereas, in embodiments in accordance with the present disclosure, the width of the target is selected to be slightly less than half an electrical period to improve robustness against positional offsets. However, when considering the previously described minimization or elimination of dead zones as well as phase shifted coil sets, the target width may be chosen in a manner to minimize the number of dead zones that it will interact with at any given time. For a single coil design this will be smaller than half an electrical cycle by at least the distance covered by a dead zone such that the target cannot be over two dead zones at the same time.

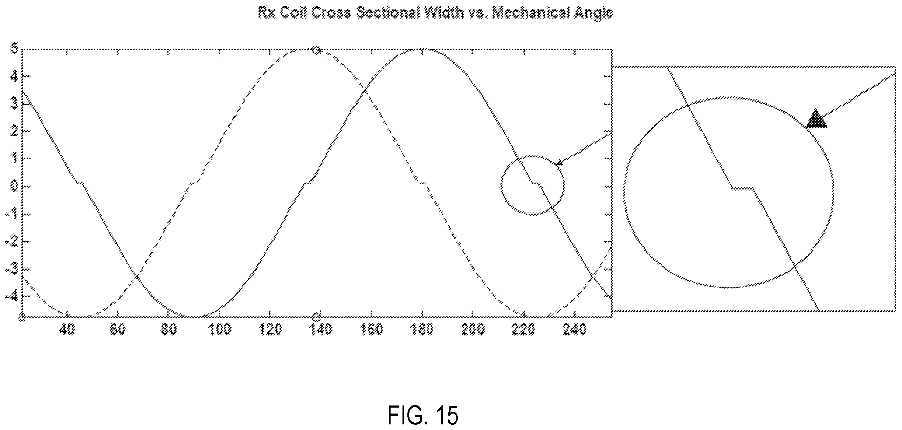

FIG. 15 illustrates a plot of receive coil cross sectional width vs. mechanical angle of an example inductive position sensor in accordance with the present disclosure. Plotting the cross sectional width of the coil loops vs. angular position shows four extended zones per electrical cycle that have zero coil width. These dead zones align with where the coil transitions from a positive to a negative loop due to trace width overlap. While the target transitions over these locations, there will be zero change in effected area in one of the receive coils, whereas the other receive coil will be changing at its peak change rate.

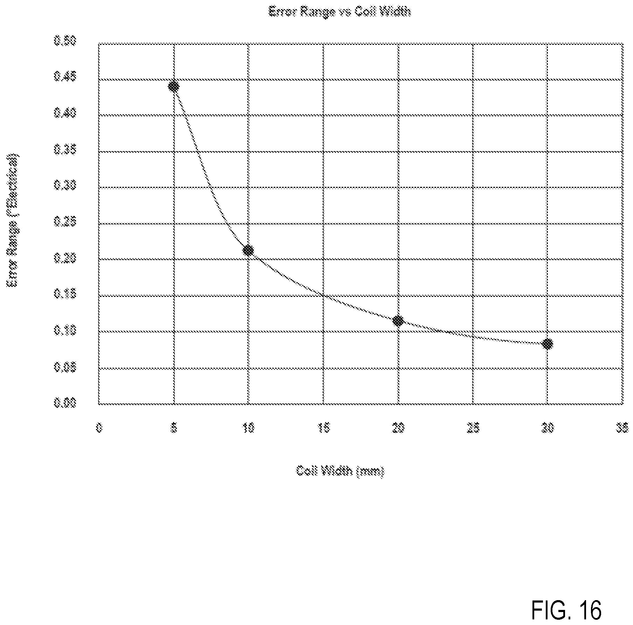

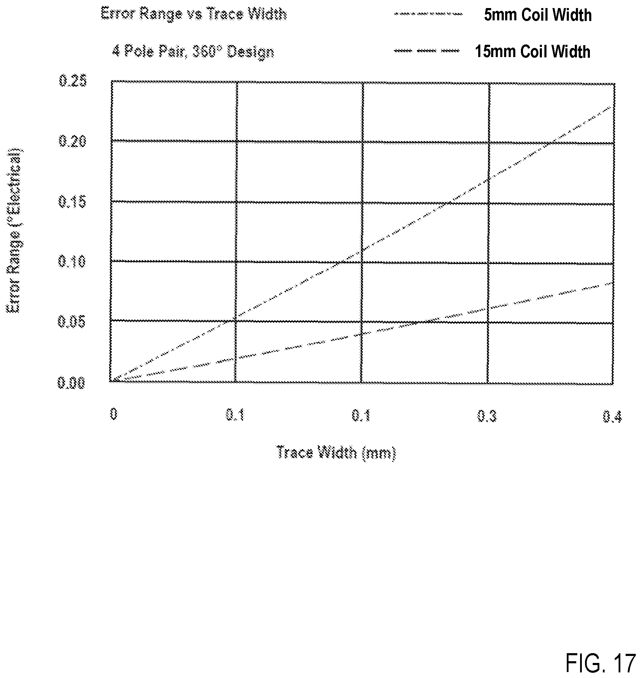

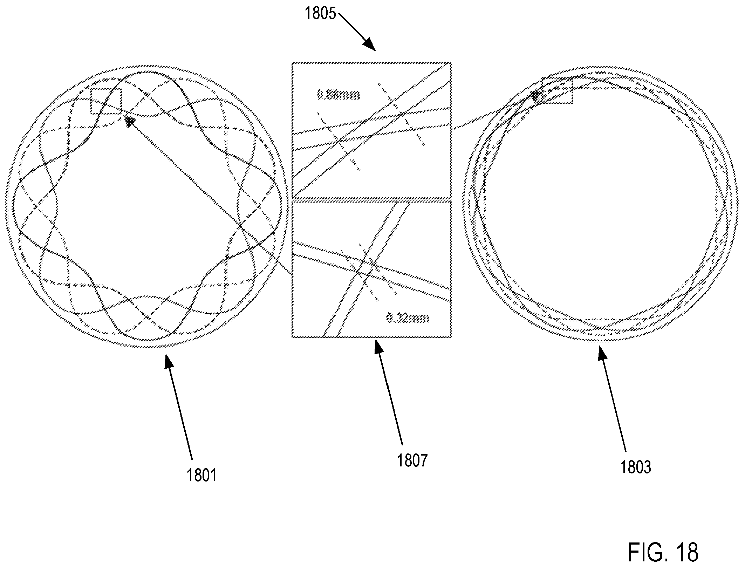

FIG. 16 illustrates a plot of error range (electrical angle) vs. coil width of an example inductive position sensor in accordance with the present disclosure. FIG. 17 illustrates a plot of error range (electrical angle) vs. trace width for a four pole pair 360 degree design of an example inductive position sensor in accordance with the present disclosure. It can be seen from FIGS. 16 and 17 that the dead zones are dependent on trace and receive coil width. FIG. 18 illustrates that a 15 mm coil (1801) width results in a 0.88 mm crossover region (1807), while a 5 mm coil (1803) width results in a 0.32 mm crossover region (1805).

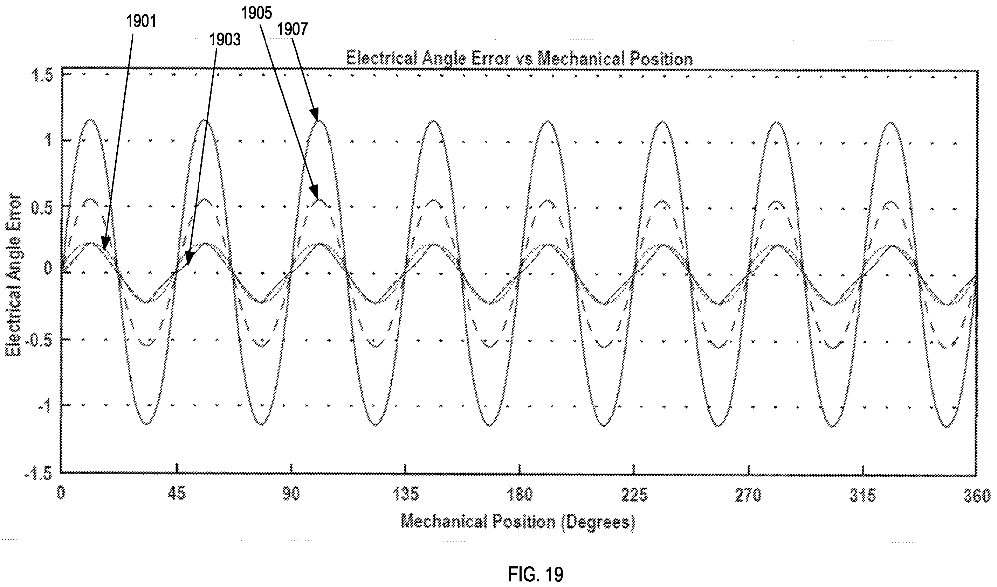

As shown in FIG. 19, a two pole pair dual coil design (in accordance with embodiments of the present disclosure decreases the magnitude of periodic error. FIG. 19 illustrates a plot of electrical angle vs. mechanical position for a single receive coil, assessing area only (1901), a single receive coil, assessing area and B-field gradient with 1 transmission coil loop (1907), dual receive coils, assessing area only (1903), and dual receive coils, assessing area and B-field gradient with 1 transmission coil loop (1905).

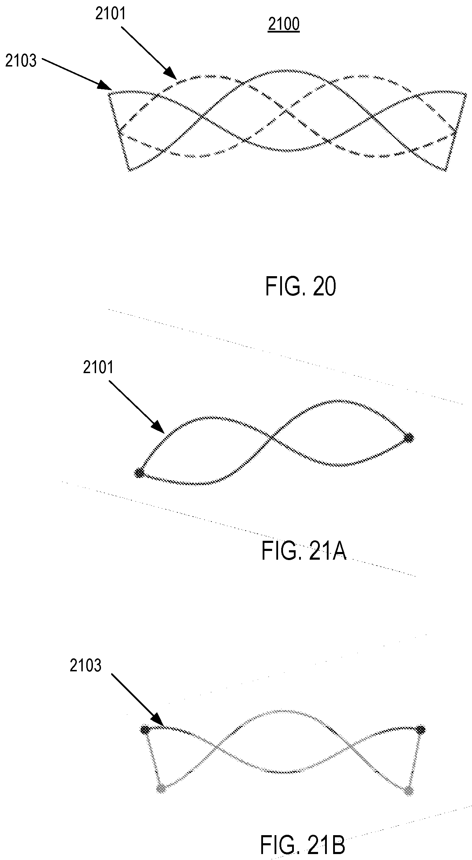

To increase balance between receive coils and maintain equal inductance the coil patterns should terminate at natural junctions in order to link and close receive loops without requiring trace segments that do not naturally occur within the sinusoidal pattern. In a standard coil this cannot be fully accomplished, as shown in the coil layout (2100) of FIG. 20. With more than one receive coil, only one could ever close at natural junction points. The additional receive coils would require extra trace segments to bridge between end points in the coil pattern. In FIG. 20A and 20B, the receive coils (2101, 2103) from FIG. 20 are split up to show the difference between a natural closed coil loop and bridged loop that requires extra trace segments to connect and close the coil loop.

In some embodiments in accordance with the present disclosure, to facilitate the use of only closed coils with natural termination, a hanging coil design employed. In these embodiments, a hanging coil has different receive signals physically offset from one another, thus occupying slightly different angular ranges within a given sensor area. For example, a 12 pole pair sensor requires 30° angular space for a full electrical period to exist. As shown in Figure 20, in a typical inductive position sensor, all receive coils (2101, 2103) would exist only within that 30°.

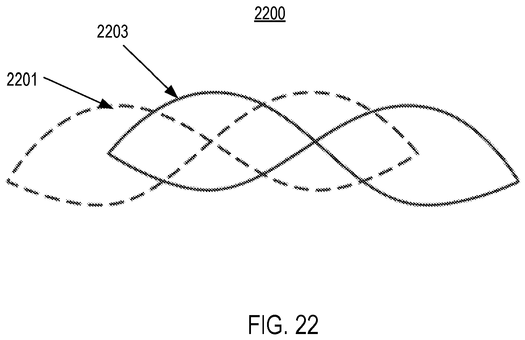

For further explanation, FIG. 22 illustrates an example hanging coil layout (2200) in accordance with some embodiments of the present disclosure. In a hanging coil layout, the termination and reflection points of one receive coil are offset from the termination and reflection points of another receive coil. That is, the termination points of one receive coil hangs off one end of an area occupied by both receive coils, and the termination points of the other receive coil hangs off the other end of the area occupied by both receive coils. For example, in FIG. 22, one receive coil (2201) occupies a 0° to 30° range and another coil (2203) occupies a 7.5°to 37.5° range. The hanging coil method provides additional utility for multiloop phase blended coils that have a higher trace density on a PCB. In some form factors it can be difficult to use phase blended coils due to the lack of available space for vias connecting traces between layers. A hanging coil can allow for the vias for one of the receive coils to be outside of the physical space that the other receive coil exists in, thus having lower trace density and more room for the via placement. In some variations, a hanging coil layout may be grouped hanging coil layout such that the termination points (and reflection points) of the angularly arrayed signals in a particular receive coil are aligned (i.e., grouped) along the same angle, where grouping angle of one receive coil is offset by some degrees with respect to the grouping angle of the another receive coil. In some variations, a hanging coil layout may be an individually spaced hanging coil layout such that the termination points (and reflection points) of the angularly arrayed signals in a particular receive coil are individually spaced apart by some degrees. In these variations, the area occupied by the individually spaced termination points (and reflection points) of one first receive coil is offset from an area occupied by the spaced termination points of another receive coil. In some variations, a hanging coil layout may be a split hanging coil layout where termination points of a first set of angularly arrayed signals are split from a second set of angularly arrayed signals by intervening termination points of another receive coil.

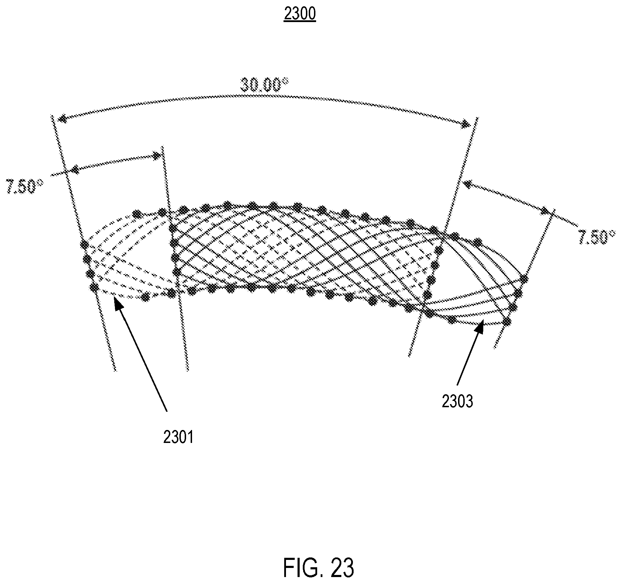

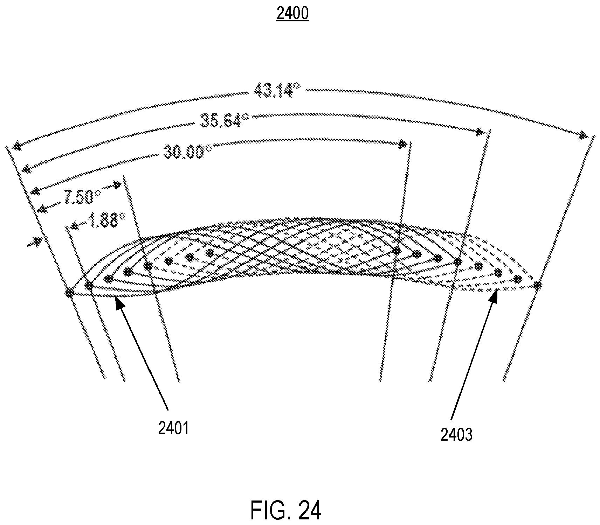

For further explanation, FIG. 23 illustrates an example grouped hanging coil layout (2300) and FIG. 24 illustrates another example individually spaced hanging coil layout (2400) in accordance with some embodiments of the present disclosure. For phase blended multiloop coils there are different ways to employ hanging coil layouts. In some examples, all of the loops for a particular receive coil (2301, 2303) are grouped and terminated together as shown in FIG. 23. In the example of FIG. 23, each receive coil (2301, 2303) occupies a 30° angular range. The termination points of each loop of the receive coil (2301) are grouped such that the loops are terminated along the same angle, which is offset by 7.5° from the angle of the grouped termination points of the receive coil (2303). Thus, the receive coil (2301) "hangs" over the receive coil (2303) on the left side of the coil layout (2300), and the receive coil (2303) hangs over the receive coil (2301) on the right side of the coil layout (2300). In other examples, each individual loop of each receive coil (2401, 2403) are spaced offset from one another as shown in FIG. 24. In the example of FIG. 24, the termination point of each loop in the receive coil (2401) is spaced 1.88° apart, and the termination point of each loop in the receive coil (2403) is spaced 1.88° apart. Each loop of each coil occupies a 30° angular range and each coil (2401, 2403) occupies a 37.5° angular range. The receive coil (2401) hangs over the receive coil (2403) 7.5° on the left and the receive coil (2403) hangs over the receive coil (2401) 7.5° on the right with a total angular range of the layout being 43.14°. Each provide different spacing options that may be better or worse for different applications depending on the size of the sensor, number of PCB layers, manufacturing capabilities, etc. The grouped hanging coils can occupy a smaller angular range than the individually spaced hanging coils, which in general makes it the more costeffective solution. For example, in a 12 pole pair, four loop, sensor the grouped hanging coil layout (2300) will occupy a total angular range of 37.5°, whereas the individually spaced hanging coil layout (2400) will occupy 43.14°. The individually spaced hanging coil may provide better blending of signal from each loop for each signal and make it more robust to positional offsets.

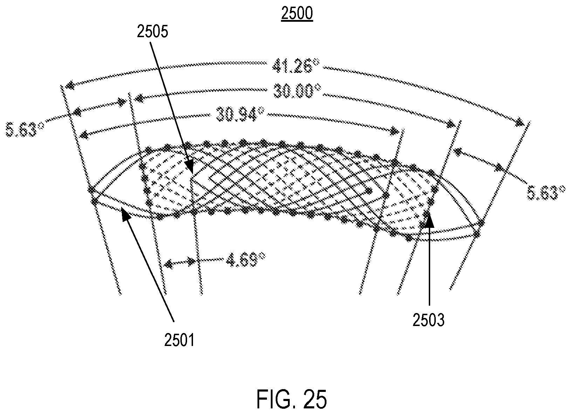

For further explanation, FIG. 25 illustrates another example hanging coil layout (2500) that is a grouped split hanging coil layout in accordance with some embodiments of the present disclosure. Hanging coils can result in imbalances due to sensor and/or target positional offsets. To improve performance under these conditions a hanging coil can be split to have one of the receive signals partially hang off of both ends of an arc sensor. In the example of FIG. 25, a first receive coil (shown in solid lines) is split such that a portion (2501) of the receive coil occupying a 41.26° angular range overhangs a second receive coil (2503) (shown in dashed lines) occupying a 30° angular range by 5.63°. The second receive coil (2503) overhangs a second portion (2505) of the first receive coil by 4.69°. That is, in the example of FIG. 25, one receive coil (dashed lines) has have all four of its loops occupying a 30° range, while the other receive coil (solid lines) has two of its loops hanging from -5.63° to 25.3° and its other two hanging from 4.69° to 35.63°. This layout decreases the trace density enough in the areas where vias are required, but also provides additional coil balance by splitting the receive coil that is at either end of the sensing region, which provides engagement with more target wings at once and offers some amount of balance for positional offsets. The grouped split hanging coil layout is suitable in coil designs that phase blend a positive number of coil loops.

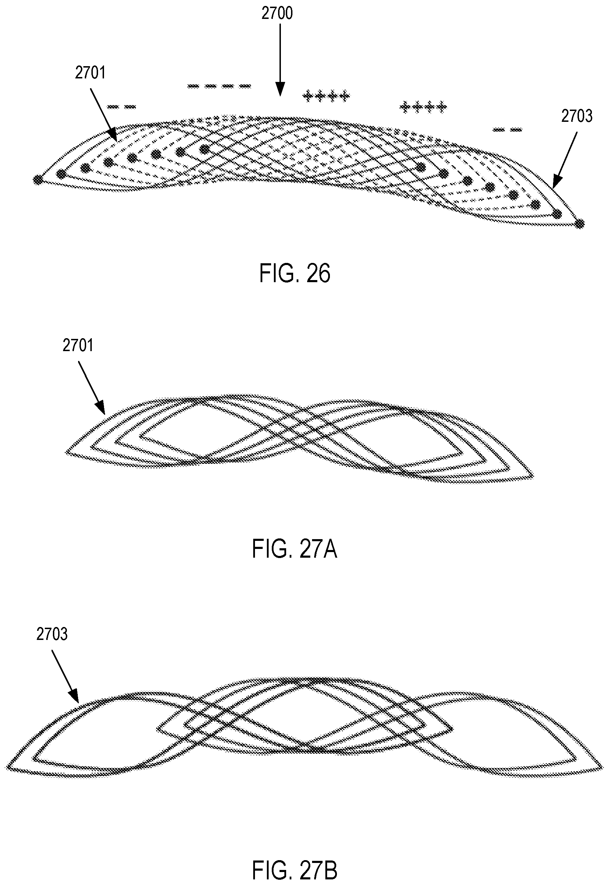

For further explanation, FIG. 26 illustrates an example hanging coil layout (2700) that is an individually spaced split hanging coil layout, with each receive coil (2701, 2703) shown separately in FIGS. 27A and 27B. In these examples, loops of the receive coil (2701) are split such that two loops of the receive coil (2701) overhang the receive coil (2703) on the left and two loops of the receive coil (2701) overhang the receive coil (2703) on the right. The loops of the receive coil (2701) are individually spaced apart, and the loops of the receive coil (2703) are individually spaced apart. This creates four negative loops and four positive loops of the coil (2703) and four positive loops of the coil (2701) that are bounded by two negative loops of the coil (2701). These examples use a single electrical period sensor, however the utility of this layout is not limited to only single electrical period coils. Hanging coil layouts can be employed on any arc sensor regardless of the number of electrical periods or poles.

In the above examples, vias are located at natural transition points of line segments, and thus would typically be located at the midline of the curves. In some applications, there are space constraints that will not allow for optimizing coil width and via placement. However, due to the size of vias, the location of transition points must be at a certain minimum radial position on the board. To maintain this position and still optimize coil loop area an asymmetric coil is employed.

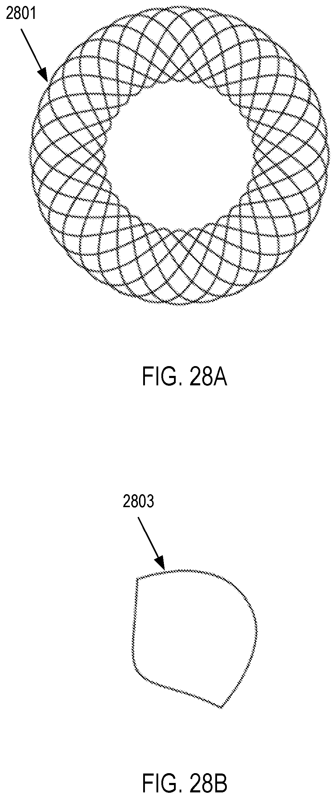

FIG. 28A illustrates an example symmetric coil pattern (2801) in accordance with the present disclosure. FIG. 28B illustrates an example loop shape (2803) of the symmetric coil pattern of FIG. 28A. In applications with high trace density it is possible to optimize coil area and via placement by having asymmetric coil widths. An inductive position sensor may employ sinusoidal trace layouts to generate the sinusoidal response from the target. These layouts may be created by having a sinusoidal trace geometry and its reflection about the midline of the sensing area. This creates a sinusoidal response that is twice the amplitude of the base coil trace geometry. In designs that utilize natural transition points for trace routing, the coil geometry defines the via placements radial position. The greater the radial position, the more area that is available for via placement. With high trace density it is important to have vias as far out radially as possible, but this is limited if the ID is too small and the resulting transition points are moved inward.

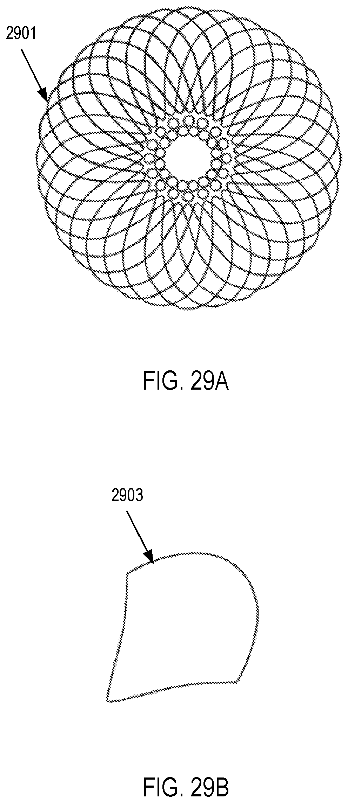

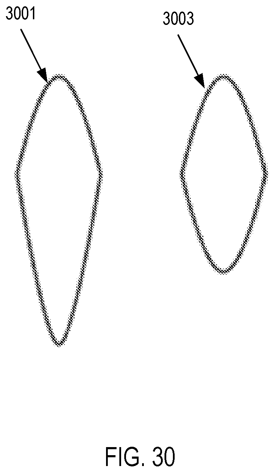

For further explanation, FIG. 29A illustrates an example asymmetric coil pattern (2901) in accordance with the present disclosure. FIG. 29B illustrates an example loop shape (2903) of the asymmetric coil pattern of FIG. 29A. To keep the transition points further out, the coil design can use two different amplitudes to generate the coil geometry. The resulting sinusoid then has an amplitude A = A1+A2. This allows for a greater overall coil width by having A2 greater than A1, but keep the vias located where they would have been with a smaller coil width and larger midline radius. The resulting greater coil sense area increase the signal amplitude of the sensor. FIG. 30 illustrates a symmetric loop shape (3003) and an asymmetric loop shape (3001) in accordance with the present disclosure on a linear scale.

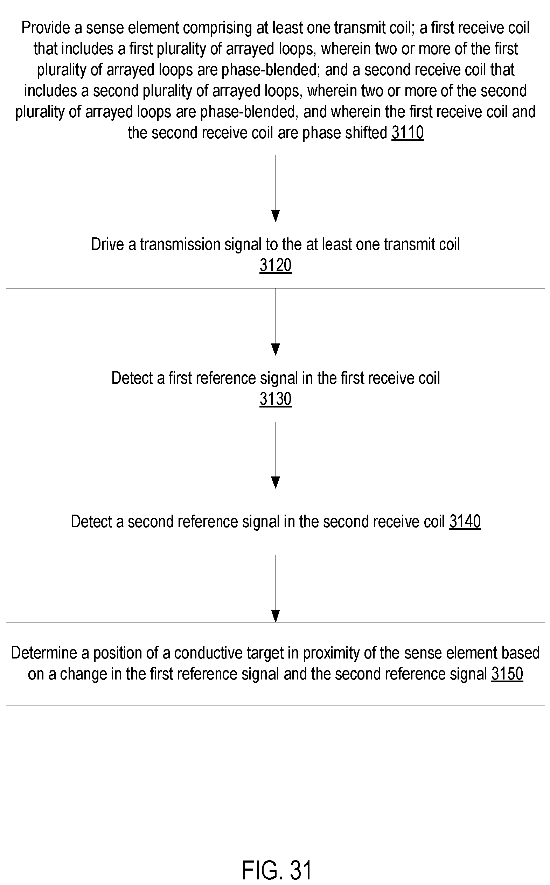

For further explanation, FIG. 31 sets forth a flow char illustrating an example method for an inductive position sensor in accordance with an embodiment of the present disclosure. The method of FIG. 31 includes providing (3110) a sense element comprising at least one transmit coil; a first receive coil that includes a first plurality of arrayed loops, wherein two or more of the first plurality of arrayed loops are at least one of phase blended and amplitude arrayed; and a second receive coil that includes a second plurality of arrayed loops, wherein two or more of the second plurality of arrayed loops are at least one of phase blended and amplitude arrayed, and wherein the first receive coil and the second receive coil are phase shifted. In some example, providing (3110) a sense element is carried out by providing an inductive position sensor having an arrayed receive coil layout such as the receive coil layouts described with reference to FIGS. 1-5, 6A, 6B, 7A, 8, 13, 14, 18, 22-26, 27A, 28A, and 29A.

The example method of FIG. 31 also includes driving (3120) the at least one transmit coil. In some example, driving (3120) the at least one transit coil includes driving the at least one transmit coil with a signal in parallel with a capacitor to generate a magnetic field that is the transmitted signal to the receive coils.

The example method of FIG. 31 also includes detecting (3130) a first reference signal in the first receive coil and detecting (3140) a second reference signal in the second receive coil. In some examples, detecting (3130) a first reference signal in the first receive coil and detecting (3140) a second reference signal in the second receive coil is carried out by an integrated circuit that detects the voltage in the first receive coil and the second receive coil induced by the magnetic field generated by the signal transmitted by the transmit coil.

The example method of FIG. 31 also includes determining (3150) a position of a conductive target in proximity of the sense element based on a change in the first reference signal and the second reference signal. In some examples, determining (3150) a position of a conductive target in proximity of the sense element based on a change in the first reference signal and the second reference signal is carried out by the integrated circuit determining the action of the first reference signal and the second reference signal. When the sense element includes an angularly or linearly arrayed (X-arrayed) coil layout, a phase blended first reference signal is summed and correlated to the mean position of the coil loops and a phase blended second reference signal is summed and correlated to the mean position of the coil loops. When the sense element includes a radially or linearly arrayed (Y-arrayed) coil layout, phase aligned signals are amplitude summed.

In view of the explanations set forth above, readers will recognize that the benefits the phase blended, arrayed, multiloop inductive coils with layout compensated geometry include increased signal strength on receive coils of an inductive position sensor, providing the purest intended sinusoidal response signal for optimal sensor performance, allowing functionality and maintain signal quality in broad range of form factors and application requirements, and decreased susceptibility to sensor and system variable's tolerance ranges and stacks. By increasing the signal strength in the receive coils, the signal to noise ratio may be increased, thresholds for proper signal conditioning can be met, and sensor sensitivity to target position under all application conditions (e.g., airgap and temperature ranges) can be improved.

## Claims

1. An inductive position sensor comprising:
a sense element (300) comprising:
at least one transmit coil (680);
a first receive coil forming a first plurality of loop sets including both phase arrayed loop sets and amplitude arrayed loop sets, wherein phase arrayed loop sets are phase shifted with respect to each other in a direction of measurement, and wherein amplitude arrayed loop sets are offset with respect to each other in a direction perpendicular to the direction of measurement; and
a second receive coil forming a second plurality of loop sets including both phase arrayed loop sets and amplitude arrayed loop sets, and wherein the first receive coil and the second receive coil are phase shifted;
wherein the amplitude arrayed loop sets of the first plurality of loop sets of the first receive coil is connected in series with the amplitude arrayed loop sets of the second plurality of loop sets of the second receive coil;
a conductive target (1303, 1403); and
an integrated circuit configured to:
provide a transmission signal to the at least one transmit coil;
detect a first reference signal in the first receive coil;
detect a second reference signal in the second receive coil; and
detect a position of the conductive target based on change in the first reference signal and the second reference signal.

2. The sensor of claim 1, wherein each loop includes a first trace pattern in a first conductive layer, a second trace pattern in a second conductive layer, and a plurality of vias connecting the first trace pattern and the second trace pattern.

3. The sensor of claims 1-2, wherein a trace pattern geometry for the first plurality of arrayed loops and the second plurality of arrayed loops is compensated for a dead zone at an intersection of two loops by offsetting two traces outward by a trace width at their intersection.

4. The sensor of claims 1-3, wherein each loop includes a first trace pattern in a first conductive layer, a second trace pattern in a second conductive layer; and wherein the first conductive layer and the second conductive layer are composed of conductive ink on printed film.

5. The sensor of claims 1-4, wherein crossovers between trace segments in the first receive coil and the second receive coil occur at natural transition points where conductor traces intersect.

6. The sensor of claims 1-5, wherein the arrayed loop sets of the first receive coil and the second receive coil each include a first set of loops that is phase arrayed with respect to a second set of loops; a third set of loops that is amplitude arrayed with respect to the first set of loops; and a fourth set of loops that is amplitude arrayed with respect to the second set of loops.

7. The sensor of claims 1-6, wherein the first receive coil and the second receive coil are comprised in an arc position sensor and are arranged in a hanging coil layout in which the loop sets of the first receive coil span a different angular range than the second receive coil.

8. The sensor of claim 7, wherein the hanging coil layout is a grouped hanging coil layout in which termination points of the loop sets of the first receive coil are radially aligned and termination points of the loop sets of the second receive coil are radially aligned.

9. The sensor of claim 7, wherein the hanging coil layout is an individually spaced hanging coil layout in which termination points of the loop sets of the first receive coil are spaced apart with respect to each other and termination points of the loop sets of the second receive coil are spaced apart with respect to each other; or
wherein the hanging coil layout is a split hanging coil layout in which a first portion of portion of the loop sets of the first receive coil span a larger angular range in the arc position sensor than the loop sets of the second receive coil, and a second portion of the loop sets of the first receive coil span a smaller angular range than the loop sets of the second receive coil.

10. The sensor of claim 1, wherein the target is selected to be less than half an electrical period of the sensor.

11. A method for an inductive position sensor, the method comprising:
providing a sense element comprising:
at least one transmit coil;
a first receive coil that includes a first plurality loop sets including both phase arrayed loop sets and amplitude arrayed loop sets, wherein phase arrayed loop sets are phase shifted with respect to each other in a direction of measurement, and wherein amplitude arrayed loop sets are offset with respect to each other in a direction perpendicular to the direction of measurement; and
a second receive coil that includes a second plurality loop sets including both phase arrayed loop sets and amplitude arrayed loop sets, wherein the first receive coil and the second receive coil are phase shifted;
wherein the amplitude arrayed loop sets of the first plurality of loop sets of the first receive coil is connected in series with the amplitude arrayed loop sets of the second plurality of loop sets of the second receive coil;
driving, by an integrated circuit, a transmission signal to the at least one transmit coil;
detecting, by the integrated circuit, a first reference signal in the first receive coil;
detecting, by the integrated circuit, a second reference signal in the second receive coil; and
determining, by the integrated circuit, a position of a conductive target in proximity of the sense element based on a change in the first reference signal and the second reference signal.

## Patentansprüche

1. Induktiver Positionssensor, umfassend:
ein Sensorelement (300), umfassend:
mindestens eine Sendespule (680);
eine erste Empfangsspule, die eine erste Mehrzahl von Schleifensätzen bildet, beinhaltend sowohl phasenangeordnete Schleifensätze als auch amplitudenangeordnete Schleifensätze, wobei phasenangeordnete Schleifensätze in Bezug zueinander in einer Messrichtung phasenverschoben sind, und wobei amplitudenangeordnete Schleifensätze in Bezug zueinander in einer Richtung senkrecht zur Messrichtung versetzt sind; und
eine zweite Empfangsspule, die eine zweite Mehrzahl von Schleifensätzen bildet, beinhaltend sowohl phasenangeordnete Schleifensätze als auch amplitudenangeordnete Schleifensätze, und wobei die erste Empfangsspule und die zweite Empfangsspule phasenverschoben sind;
wobei die amplitudenangeordneten Schleifensätze der ersten Mehrzahl von Schleifensätzen der ersten Empfangsspule mit den amplitudenangeordneten Schleifensätzen der zweiten Mehrzahl von Schleifensätzen der zweiten Empfangsspule in Reihe geschaltet sind;
ein leitfähiges Target (1303, 1403); und
eine integrierte Schaltung, konfiguriert zum:
Bereitstellen eines Übertragungssignals an die mindestens eine Sendespule;
Detektieren eines ersten Referenzsignals in der ersten Empfangsspule;
Detektieren eines zweiten Referenzsignals in der zweiten Empfangsspule; und
Detektieren einer Position des leitfähigen Targets basierend auf einer Änderung des ersten Referenzsignals und des zweiten Referenzsignals.

2. Sensor nach Anspruch 1, wobei jede Schleife ein erstes Leiterbahnmuster in einer ersten leitfähigen Schicht, ein zweites Leiterbahnmuster in einer zweiten leitfähigen Schicht und eine Mehrzahl von Durchkontaktierungen, die das erste Leiterbahnmuster und das zweite Leiterbahnmuster verbinden, beinhaltet.

3. Sensor nach den Ansprüchen 1-2, wobei eine Leiterbahnmustergeometrie für die erste Mehrzahl von angeordneten Schleifen und die zweite Mehrzahl von angeordneten Schleifen für eine Totzone an einer Kreuzung zweier Schleifen kompensiert ist, indem zwei Leiterbahnen an ihrer Kreuzung um eine Leiterbahnbreite nach außen versetzt sind.

4. Sensor nach den Ansprüchen 1-3, wobei jede Schleife ein erstes Leiterbahnmuster in einer ersten leitfähigen Schicht, ein zweites Leiterbahnmuster in einer zweiten leitfähigen Schicht beinhaltet; und wobei die erste leitfähige Schicht und die zweite leitfähige Schicht aus leitfähiger Tinte auf gedruckter Folie bestehen.

5. Sensor nach den Ansprüchen 1-4, wobei Überkreuzungen zwischen Leiterbahnsegmenten in der ersten Empfangsspule und der zweiten Empfangsspule an natürlichen Übergangspunkten auftreten, an denen sich Leiterbahnen kreuzen.

6. Sensor nach den Ansprüchen 1-5, wobei die angeordneten Schleifensätze der ersten Empfangsspule und der zweiten Empfangsspule jeweils einen ersten Satz von Schleifen, der in Bezug auf einen zweiten Satz von Schleifen phasenangeordnet ist, beinhalten; einen dritten Satz von Schleifen, der in Bezug auf den ersten Satz von Schleifen amplitudenangeordnet ist; und einen vierten Satz von Schleifen, der in Bezug auf den zweiten Satz von Schleifen amplitudenangeordnet ist.

7. Sensor nach den Ansprüchen 1-6, wobei die erste Empfangsspule und die zweite Empfangsspule in einem Bogenpositionssensor enthalten sind und in einer hängenden Spulenanordnung angeordnet sind, in der die Schleifensätze der ersten Empfangsspule einen anderen Winkelbereich als die zweite Empfangsspule überspannen.

8. Sensor nach Anspruch 7, wobei die hängende Spulenanordnung eine gruppierte hängende Spulenanordnung ist, in der Abschlusspunkte der Schleifensätze der ersten Empfangsspule radial ausgerichtet sind und Abschlusspunkte der Schleifensätze der zweiten Empfangsspule radial ausgerichtet sind.

9. Sensor nach Anspruch 7, wobei die hängende Spulenanordnung eine einzeln beabstandete hängende Spulenanordnung ist, in der Abschlusspunkte der Schleifensätze der ersten Empfangsspule in Bezug zueinander beabstandet sind und Abschlusspunkte der Schleifensätze der zweiten Empfangsspule in Bezug zueinander beabstandet sind; oder
wobei die hängende Spulenanordnung eine geteilte hängende Spulenanordnung ist, in der ein erster Abschnitt von Abschnitt der Schleifensätze der ersten Empfangsspule einen größeren Winkelbereich in dem Bogenpositionssensor als die Schleifensätze der zweiten Empfangsspule überspannen, und ein zweiter Abschnitt der Schleifensätze der ersten Empfangsspule einen kleineren Winkelbereich als die Schleifensätze der zweiten Empfangsspule überspannen.

10. Sensor nach Anspruch 1, wobei das Target so ausgewählt ist, dass es weniger als eine halbe elektrische Periode des Sensors beträgt.

11. Verfahren für einen induktiven Positionssensor, wobei das Verfahren umfasst:
Bereitstellen eines Sensorelements, umfassend:
mindestens eine Sendespule;
eine erste Empfangsspule, die eine erste Mehrzahl von Schleifensätzen beinhaltet, beinhaltend sowohl phasenangeordnete Schleifensätze als auch amplitudenangeordnete Schleifensätze, wobei phasenangeordnete Schleifensätze in Bezug zueinander in einer Messrichtung phasenverschoben sind, und wobei amplitudenangeordnete Schleifensätze in Bezug zueinander in einer Richtung senkrecht zur Messrichtung versetzt sind; und
eine zweite Empfangsspule, die eine zweite Mehrzahl von Schleifensätzen beinhaltet, beinhaltend sowohl phasenangeordnete Schleifensätze als auch amplitudenangeordnete Schleifensätze, wobei die erste Empfangsspule und die zweite Empfangsspule phasenverschoben sind;
wobei die amplitudenangeordneten Schleifensätze der ersten Mehrzahl von Schleifensätzen der ersten Empfangsspule mit den amplitudenangeordneten Schleifensätzen der zweiten Mehrzahl von Schleifensätzen der zweiten Empfangsspule in Reihe geschaltet sind;
Ansteuern, durch eine integrierte Schaltung, eines Übertragungssignals an die mindestens eine Sendespule;
Detektieren, durch die integrierte Schaltung, eines ersten Referenzsignals in der ersten Empfangsspule;
Detektieren, durch die integrierte Schaltung, eines zweiten Referenzsignals in der zweiten Empfangsspule; und
Bestimmen, durch die integrierte Schaltung, einer Position eines leitfähigen Targets in der Nähe des Sensorelements basierend auf einer Änderung des ersten Referenzsignals und des zweiten Referenzsignals.

## Revendications

1. Capteur de position inductif comprenant :
un élément de captage (300) comprenant :
au moins une bobine d'émission (680) ;
une première bobine de réception formant une première pluralité d'ensembles de boucles comportant à la fois des ensembles de boucles à réseau de phase et des ensembles de boucles à réseau d'amplitude, dans lequel les ensembles de boucles à réseau de phase sont déphasés les uns par rapport aux autres dans une direction de mesure, et dans lequel les ensembles de boucles à réseau d'amplitude sont décalés les uns par rapport aux autres dans une direction perpendiculaire à la direction de mesure ; et
une seconde bobine de réception formant une seconde pluralité d'ensembles de boucles comportant à la fois des ensembles de boucles à réseau de phase et des ensembles de boucles à réseau d'amplitude, et dans lequel la première bobine de réception et la seconde bobine de réception sont déphasées ;
dans lequel les ensembles de boucles à réseau d'amplitude de la première pluralité d'ensembles de boucles de la première bobine de réception sont connectés en série avec les ensembles de boucles à réseau d'amplitude de la seconde pluralité d'ensembles de boucles de la seconde bobine de réception ;
une cible conductrice (1303, 1403) ; et
un circuit intégré configuré pour :
fournir un signal d'émission à l'au moins une bobine d'émission ;
détecter un premier signal de référence dans la première bobine de réception ;
détecter un second signal de référence dans la seconde bobine de réception ; et
détecter une position de la cible conductrice en fonction d'une variation du premier signal de référence et du second signal de référence.

2. Capteur selon la revendication 1, dans lequel chaque boucle comporte un premier motif de trace dans une première couche conductrice, un second motif de trace dans une seconde couche conductrice et une pluralité de trous d'interconnexion connectant le premier motif de trace et le second motif de trace.

3. Capteur selon les revendications 1 à 2, dans lequel la géométrie de motif de trace pour la première pluralité de boucles à réseau et la seconde pluralité de boucles à réseau est compensée pour une zone morte au niveau de l'intersection de deux boucles en décalant deux traces vers l'extérieur d'une largeur de trace au niveau de leur intersection.

4. Capteur selon les revendications 1 à 3, dans lequel chaque boucle comporte un premier motif de trace dans une première couche conductrice, un second motif de trace dans une seconde couche conductrice ; et dans lequel la première couche conductrice et la seconde couche conductrice sont composées d'encre conductrice sur un film imprimé.

5. Capteur selon les revendications 1 à 4, dans lequel les croisements entre les segments de trace dans la première bobine de réception et la seconde bobine de réception se produisent au niveau de points de transition naturels où les traces conductrices se croisent.

6. Capteur selon les revendications 1 à 5, dans lequel les ensembles de boucles à réseau de la première bobine de réception et de la seconde bobine de réception comportent chacun un premier ensemble de boucles qui est à réseau de phase par rapport à un deuxième ensemble de boucles ; un troisième ensemble de boucles qui est à réseau d'amplitude par rapport au premier ensemble de boucles ; et un quatrième ensemble de boucles qui est à réseau d'amplitude par rapport au deuxième ensemble de boucles.

7. Capteur selon les revendications 1 à 6, dans lequel la première bobine de réception et la seconde bobine de réception sont comprises dans un capteur de position d'arc et sont agencées dans une disposition de bobine suspendue dans laquelle les ensembles de boucles de la première bobine de réception couvrent une plage angulaire différente de ceux de la seconde bobine de réception.

8. Capteur selon la revendication 7, dans lequel la disposition de bobine suspendue est une disposition de bobine suspendue groupée dans laquelle des points de terminaison des ensembles de boucles de la première bobine de réception sont alignés radialement et des points de terminaison des ensembles de boucles de la seconde bobine de réception sont alignés radialement.

9. Capteur selon la revendication 7, dans lequel la disposition de bobine suspendue est une disposition de bobine suspendue à espacement individuel dans laquelle des points de terminaison des ensembles de boucles de la première bobine de réception sont espacés les uns des autres et des points de terminaison des ensembles de boucles de la seconde bobine de réception sont espacés les uns des autres ; ou
dans lequel la disposition de bobine suspendue est une disposition de bobine suspendue divisée dans laquelle une première partie de partie des ensembles de boucles de la première bobine de réception couvre une plage angulaire plus grande dans le capteur de position d'arc que les ensembles de boucles de la seconde bobine de réception, et une seconde partie des ensembles de boucles de la première bobine de réception couvre une plage angulaire plus petite que les ensembles de boucles de la seconde $bobine de réception.

10. Capteur selon la revendication 1, dans lequel la cible est choisie de manière à être inférieure à la moitié d'une période électrique du capteur.

11. Procédé pour capteur de position inductif, le procédé comprenant :
la fourniture d'un élément de captage comprenant :
au moins une bobine d'émission ;
une première bobine de réception qui comporte une première pluralité d'ensembles de boucles comportant à la fois des ensembles de boucles à réseau de phase et des ensembles de boucles à réseau d'amplitude, dans lequel les ensembles de boucles à réseau de phase sont déphasés les uns par rapport aux autres dans une direction de mesure, et dans lequel les ensembles de boucles à réseau d'amplitude sont décalés les uns par rapport aux autres dans une direction perpendiculaire à la direction de mesure ; et
une seconde bobine de réception qui comporte une seconde pluralité d'ensembles de boucles comportant à la fois des ensembles de boucles à réseau de phase et des ensembles de boucles à réseau d'amplitude, et dans lequel la première bobine de réception et la seconde bobine de réception sont déphasées ;
dans lequel les ensembles de boucles à réseau d'amplitude de la première pluralité d'ensembles de boucles de la première bobine de réception sont connectés en série avec les ensembles de boucles à réseau d'amplitude de la seconde pluralité d'ensembles de boucles de la seconde bobine de réception ;
l'entraînement, par un circuit intégré, d'un signal de transmission vers l'au moins une bobine d'émission ;
la détection, par le circuit intégré, d'un premier signal de référence dans la première bobine de réception ;
la détection, par le circuit intégré, d'un second signal de référence dans la seconde bobine de réception ; et
la détermination, par le circuit intégré, d'une position d'une cible conductrice à proximité de l'élément de captage en fonction d'une variation du premier signal de référence et du second signal de référence.
